# EUROPÄISCHE PATENTANMELDUNG

(11) **EP 4 650 083 A1**
(43) Veröffentlichungstag der Anmeldung: **19.11.2025**
(21) Anmeldenummer: 25174654.1
(22) Anmeldetag: 06.05.2025
(51) Int. Cl.: B22D 19/00, G03F 7/00

(54) **VERFAHREN ZUR HERSTELLUNG EINES MODULS FÜR DIE HALBLEITERLITHOGRAPHIE UND MODUL FÜR DIE HALBLEITERLITHOGRAPHIE**

(30) Priorität: 16.05.2024 DE 102024204548
(71) Anmelder: Carl Zeiss SMT GmbH, 73447 Oberkochen (DE)
(72) Erfinder: OBERMAIER, Stefan, 73447 Oberkochen (DE); JOCHMANN, Almut, 73447 Oberkochen (DE)
(74) Vertreter: Raunecker, Klaus Peter

(57) **Zusammenfassung**

Die Erfindung betrifft ein Verfahren zur Herstellung eines Moduls (40) für die Halbleiterlithografie mit einem Grundkörper (41.2), wobei in dem Grundkörper (41.2) mindestens ein Rohr (42) angeordnet ist, welches den Grundkörper (41.2) an mindestens einer Stelle (45) durchdringt, mit folgenden Verfahrensschritten:
- Fügen einer Hülse (49.1,49.2) mit dem Rohr (veränderte) im Bereich des Austritts (45) des Rohrs (42) aus dem Grundkörper (41.2),
- Positionierung des Rohrs (42) in einer Gussform zur Herstellung des Grund-körpers (41.2),
- Gießen des Grundkörpers (41.2),
- Nachbearbeitung des Grundkörpers (41.2).

Weiterhin betrifft die Erfindung ein Modul (40) für die Halbleiterlithografie mit einem Grundkörper (41.2), wobei in dem Grundkörper (41.2) mindestens ein Rohr (42) angeordnet ist, welches den Grundkörper (41.2) an mindestens einer Stelle durchdringt. Das Modul (40) zeichnet sich dadurch aus, dass das Rohr (42) spaltfrei von einer Hülse (49.1,49.2) des Grundkörpers (41.2) umschlossen ist.

## Beschreibung

Die Erfindung betrifft ein Verfahren zur Herstellung eines Moduls für die Halbleiterlithographie und ein Modul für die Halbleiterlithographie, insbesondere für eine Projektionsbelichtungsanlage.

Projektionsbelichtungsanlagen für die Halbleiterlithografie unterliegen extrem hohen Anforderungen an die Abbildungsqualität, um die gewünschten mikroskopisch kleinen Strukturen möglichst fehlerfrei herstellen zu können. In einem Lithografieprozess oder einem Mikrolithografieprozess beleuchtet ein Beleuchtungssystem eine fotolithografische Maske, die auch als Retikel bezeichnet wird. Das durch die Maske hindurchtretende Licht oder das von der Maske reflektierte Licht wird von einer Projektionsoptik auf ein mit einer lichtempfindlichen Schicht (Fotoresist) beschichtetes, in der Bildebene der Projektionsoptik angebrachtes Substrat (beispielsweise einen Wafer) projiziert, um die Strukturelemente der Maske auf die lichtempfindliche Beschichtung des Substrats zu übertragen. Die Anforderungen an die Positionierung der Abbildung auf dem Wafer und die Intensität des durch das Beleuchtungssystem bereitgestellten Lichts werden mit jeder neuen Generation erhöht, was zu einer höheren Wärmelast auf den optischen Elementen führt.

In Fällen hoher Wärmelast kann es von Vorteil sein, bestimmte Module, wie beispielsweise Tragrahmen, Referenzrahmen oder optische Module, insbesondere in EUV-Projektionsbelichtungsanlagen, also in Anlagen, die mit elektromagnetischer Strahlung der Wellenlänge zwischen 1nm und 120nm, insbesondere bei 13,5nm betrieben werden, durch eine Wasserkühlung zu temperieren. Auch in DUV-Projektionsbelichtungsanlagen, also in Anlagen, die mit elektromagnetischer Strahlung mit einer Wellenlänge zwischen 100nm und 300nm betrieben werden, können wassergekühlte Module zum Einsatz kommen. Diese Module umfassen Fluidkanäle, die üblicherweise von temperiertem Wasser durchströmt werden, wodurch die Wärme von den Modulen wegführt wird. Die Fluidkanäle werden üblicherweise durch Eingießen einer Leitung in einen Grundkörper eines Rahmens oder eines Moduls erzeugt. Dabei wird beispielsweise eine als Kühlspirale ausgebildete Leitung über Halterungen in einer Gussform angeordnet und umgossen. Die Kühlleitungen sind auf Grund der notwendigen Beständigkeit gegen das üblicherweise als Wasser ausgebildete Kühlfluid häufig aus Edelstahl ausgebildet, wogegen der Grundkörper auf Grund der gewünschten hohen Wärmeleitfähigkeit bevorzugt aus Aluminium oder einer Aluminiumlegierung erzeugt wird. Die verfahrensbedingten Temperaturen während des Gießens führen nicht zum Anschmelzen der Kühlleitung, wodurch sich zwischen der Kühlleitung und dem Grundkörper ein Formschluss, also kein Stoffschluss ausbildet. Dieses Verfahren hat den Nachteil, dass der Grundkörper zwar bei der Abkühlung im Fall von Aluminium durch dessen höhere Wärmeausdehnung im Inneren auf die Kühlleitung aus Edelstahl aufgeschrumpft wird, es aber im Austrittsbereich verfahrensbedingt zu einer leichten Spaltbildung zwischen der Kühlleitung und dem Grundrahmen kommt. Diese kann beispielsweise durch die Kapillarwirkung bzw. die Oberflächenspannung erklärt werden.

Die Gussoberfläche, insbesondere bei Sandguss, kann nicht oder nur sehr schwer für die speziellen Anforderungen im Bereich der EUV-Lithographie gereinigt werden. Daher ist aus Sauberkeitsgründen eine Nachbearbeitung aller Oberflächen notwendig. Das Verfahren hat den weiteren Nachteil, dass die Positionsgenauigkeit der Kühlleitung im Grundkörper verfahrensbedingt relativ großen Toleranzen unterliegt, so dass eine präzise mechanische Nachbearbeitung, insbesondere im Bereich des Austritts der Kühlleitung aus dem Grundkörper nicht möglich ist und somit der mögliche Spalt und insbesondere die raue Oberfläche nicht durch die Nachbearbeitung entfernt werden können. Die Reinigungsanforderungen können damit nicht oder nur mit erheblichem Aufwand eingehalten werden.

Aufgabe der vorliegenden Erfindung ist es, eine Vorrichtung bereitzustellen, welche die oben erläuterten Nachteile des Standes der Technik beseitigt. Weiterhin ist es eine Aufgabe der vorliegenden Erfindung, ein Verfahren zur Herstellung der Vorrichtung anzugeben.

Diese Aufgabe wird gelöst durch eine Vorrichtung und ein Verfahren mit den Merkmalen der unabhängigen Ansprüche. Die Unteransprüche betreffen vorteilhafte Weiterbildungen und Varianten der Erfindung.

Ein erfindungsgemäßes Verfahren zur Herstellung eines Moduls für die Halbleiterlithografie mit einem Grundkörper, wobei in dem Grundkörper mindestens ein Rohr angeordnet ist, welches den Grundkörper an mindestens einer Stelle durchdringt, umfasst folgende Verfahrensschritte:
- Fügen einer Hülse mit dem Rohr im Bereich des Austritts des Rohrs aus dem Grundkörper, beispielsweise durch Aufschrumpfen
- Positionierung des Rohrs in einer Gussform zur Herstellung des Grundkörpers
- Gießen des Grundkörpers
- Nachbearbeitung des Grundkörpers

Die Hülse ermöglicht es, die Oberflächen des Moduls in einer Qualität herzustellen, welche die erhöhten Anforderungen im Bereich der Halbleiterlithographie, insbesondere innerhalb einer Projektionsbelichtungsanlage, erfüllt.

In einem weiteren Verfahrensschritt kann das Rohr durch mindestens eine Stützstruktur in der Gussform positioniert werden. Dadurch kann sichergestellt werden, dass das Rohr nach dem Vergießen des Grundkörpers an den vorbestimmten Positionen im Grundkörper des Moduls angeordnet ist.

Weiterhin können das Rohr, die Hülse und die Stützstrukturen beim Gießen zumindest teilweise von der Schmelze umschlossen werden. Das Rohr, die Hülse als auch die Stützstrukturen können nach dem Gießen die Außenflächen des Moduls durchdringen, wobei insbesondere die überstehenden Bereiche der Stützstrukturen beim Nacharbeiten der Außenflächen des Moduls zur Erstellung einer den Anforderungen für eine ausreichende Reinigung genügenden Oberflächenrauheit vollständig entfernt werden.

Daneben können die Hülse und die Stützstrukturen beim Gießen zumindest teilweise von der Schmelze angeschmolzen werden. Dabei kann im Idealfall das Anschmelzen der Hülse bzw. der Stützstrukturen derart erfolgen, dass einerseits eine stoffschlüssige Verbindung zwischen der Schmelze und den Bauteilen erzeugt werden kann und andererseits die Positionierung der Rohre und der Hülse sichergestellt werden kann.

In einer weiteren Ausführungsform kann mindestens eine Stirnseite der Hülse vor dem Fügen mit dem Rohr eine Oberflächenrauheit von kleiner als Rz 6,3, bevorzugt von kleiner als Rz 2,5 und besonders bevorzugt von kleiner Rz 1,0 aufweisen. Dies ist sinnvoll, um eine ausreichende Reinigung der Stirnfläche sicherzustellen, da eine Nachbearbeitung der Stirnfläche nach dem Aufbringen auf das Rohr immer das Risiko einer Beschädigung des Rohrs in sich birgt.

Insbesondere können die Stützstrukturen und die Hülse aus demselben Material wie der Grundkörper hergestellt werden. Dies vereinfacht die weiter oben erläuterte stoffschlüssige Verbindung und kann aufgrund von unterschiedlichen Wärmeausdehnungskoeffizienten unterschiedlicher Materialien verursachte Lunker im Grundkörpers des Moduls vorteilhaft vermeiden.

Weiterhin können die Hülse und/oder die Mantelfläche des Gehäuses nach dem Gießen des Grundkörpers zumindest teilweise zur Herstellung einer spaltfreien Verbindung zwischen Hülse und dem Grundkörper und/oder zur Herstellung einer Oberflächenrauheit von kleiner als Rz 6,3, bevorzugt von kleiner als Rz 2,5 und besonders bevorzugt von kleiner Rz 1,0 nachgearbeitet werden, insbesondere mittels eines spanenden Verfahrens. Ein möglicherweise beim Gießen verursachter Spalt zwischen dem Gehäuse und der Hülse, welcher üblicherweise nur einige Zehntel Millimeter tief ausgebildet ist, kann vorteilhafterweise durch die spanende Bearbeitung entfernt werden. Dies hat den Vorteil, dass die gesamte Außenfläche des Gehäuses spaltfrei ausgebildet sein kann und eine ausreichende geringe Oberflächenrauheit, wie weiter oben erläutert, aufweisen kann.

Ein erfindungsgemäßes Modul für die Halbleiterlithografie mit einem Grundkörper, wobei in dem Grundkörper mindestens ein Rohr angeordnet ist, welches den Grundkörper an mindestens einer Stelle durchdringt, zeichnet sich dadurch aus, dass das Rohr spaltfrei von einer Hülse des Grundkörpers umschlossen ist. Dies kann, wie weiter oben erwähnt, durch das Aufschrumpfen der Hülse auf das Rohr vor dem Gießen des Grundkörpers sichergestellt werden.

Weiterhin kann die Hülse spaltfrei vom Grundkörper umschlossen sein. Ein möglicherweise aufgrund der Kapillarwirkung zwischen Gussform und Hülse bzw. der Oberflächenspannung der Schmelze ausgebildete Spalt zwischen der Hülse und dem Grundkörpers kann bei der Nachbearbeitung des Grundkörpers durch einen der Tiefe des Spaltes korrespondierenden Abtrag leicht entfernt werden.

Insbesondere kann die Oberfläche des Moduls eine Oberflächenrauheit von kleiner als Rz 6,3, bevorzugt von kleiner als Rz 2,5 und besonders bevorzugt von kleiner Rz 1,0 aufweisen. Dies kann eine ausreichende Reinigung des Moduls für den Einsatz in der Halbleiterlithographie, insbesondere in einer Projektionsbelichtungsanlage, sicherstellen.

In einer weiteren Ausführungsform können die Hülse und/oder die Stützstrukturen dasselbe Material wie der Grundkörper aufweisen, woraus sich die weiter oben bereits erläuterten Vorteile ergeben.

Nachfolgend werden Ausführungsbeispiele und Varianten der Erfindung anhand der Zeichnung näher erläutert. Es zeigen
- Figur 1: schematisch im Meridionalschnitt eine Projektionsbelichtungsanlage für die EUV-Projektionslithografie,
- Figur 2: schematisch im Meridionalschnitt eine Projektionsbelichtungsanlage für die DUV-Projektionslithografie,
- Figur 3a,3b: ein aus dem Stand der Technik bekanntes Modul, und
- Figur 4: ein Detail eines erfindungsgemäßen Moduls.

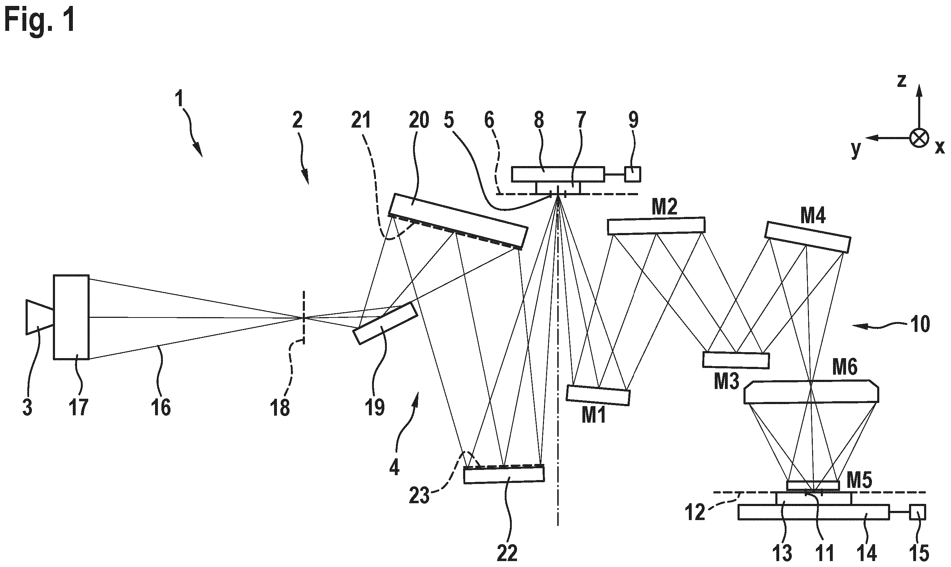

Im Folgenden werden zunächst unter Bezugnahme auf die Figur 1 exemplarisch die wesentlichen Bestandteile einer Projektionsbelichtungsanlage 1 für die Mikrolithografie beschrieben. Die Beschreibung des grundsätzlichen Aufbaus der Projektionsbelichtungsanlage 1 sowie deren Bestandteile sind hierbei nicht einschränkend verstanden.

Eine Ausführung eines Beleuchtungssystems 2 der Projektionsbelichtungsanlage 1 hat neben einer Strahlungsquelle 3 eine Beleuchtungsoptik 4 zur Beleuchtung eines Objektfeldes 5 in einer Objektebene 6. Bei einer alternativen Ausführung kann die Lichtquelle 3 auch als ein zum sonstigen Beleuchtungssystem separates Modul bereitgestellt sein. In diesem Fall umfasst das Beleuchtungssystem die Lichtquelle 3 nicht.

Beleuchtet wird ein im Objektfeld 5 angeordnetes Retikel 7. Das Retikel 7 ist von einem Retikelhalter 8 gehalten. Der Retikelhalter 8 ist über einen Retikelverlagerungsantrieb 9 insbesondere in einer Scanrichtung verlagerbar.

In der Figur 1 ist zur Erläuterung ein kartesisches xyz-Koordinatensystem eingezeichnet. Die x-Richtung verläuft senkrecht zur Zeichenebene hinein. Die y-Richtung verläuft horizontal und die z-Richtung verläuft vertikal. Die Scanrichtung verläuft in der Fig. 1 längs der y-Richtung. Die z-Richtung verläuft senkrecht zur Objektebene 6.

Die Projektionsbelichtungsanlage 1 umfasst eine Projektionsoptik 10. Die Projektionsoptik 10 dient zur Abbildung des Objektfeldes 5 in ein Bildfeld 11 in einer Bildebene 12. Die Bildebene 12 verläuft parallel zur Objektebene 6. Alternativ ist auch ein von 0° verschiedener Winkel zwischen der Objektebene 6 und der Bildebene 12 möglich.

Abgebildet wird eine Struktur auf dem Retikel 7 auf eine lichtempfindliche Schicht eines im Bereich des Bildfeldes 11 in der Bildebene 12 angeordneten Wafers 13. Der Wafer 13 wird von einem Waferhalter 14 gehalten. Der Waferhalter 14 ist über einen Waferverlagerungsantrieb 15 insbesondere längs der y-Richtung verlagerbar. Die Verlagerung einerseits des Retikels 7 über den Retikelverlagerungsantrieb 9 und andererseits des Wafers 13 über den Waferverlagerungsantrieb 15 kann synchronisiert zueinander erfolgen.

Bei der Strahlungsquelle 3 handelt es sich um eine EUV-Strahlungsquelle. Die Strahlungsquelle 3 emittiert insbesondere EUV-Strahlung 16, welche im Folgenden auch als Nutzstrahlung, Beleuchtungsstrahlung oder Beleuchtungslicht bezeichnet wird. Die Nutzstrahlung hat insbesondere eine Wellenlänge im Bereich zwischen 5 nm und 30 nm. Bei der Strahlungsquelle 3 kann es sich um eine Plasmaquelle handeln, zum Beispiel um eine LPP-Quelle (Laser Produced Plasma, mithilfe eines Lasers erzeugtes Plasma) oder um eine DPP-Quelle (Gas Discharged Produced Plasma, mittels Gasentladung erzeugtes Plasma). Es kann sich auch um eine synchrotronbasierte Strahlungsquelle handeln. Bei der Strahlungsquelle 3 kann es sich um einen Freie-Elektronen-Laser (Free-Electron-Laser, FEL) handeln.

Die Beleuchtungsstrahlung 16, die von der Strahlungsquelle 3 ausgeht, wird von einem Kollektor 17 gebündelt. Bei dem Kollektor 17 kann es sich um einen Kollektor mit einer oder mit mehreren ellipsoidalen und/oder hyperboloiden Reflexionsflächen handeln. Die mindestens eine Reflexionsfläche des Kollektors 17 kann im streifenden Einfall (Grazing Incidence, GI), also mit Einfallswinkeln größer als 45° gegenüber der Normalenrichtung der Spiegeloberfläche, oder im normalen Einfall (Normal Incidence, NI), also mit Einfallwinkeln kleiner als 45°, mit der Beleuchtungsstrahlung 16 beaufschlagt werden. Der Kollektor 17 kann einerseits zur Optimierung seiner Reflektivität für die Nutzstrahlung und andererseits zur Unterdrückung von Falschlicht strukturiert und/oder beschichtet sein.

Nach dem Kollektor 17 propagiert die Beleuchtungsstrahlung 16 durch einen Zwischenfokus in einer Zwischenfokusebene 18. Die Zwischenfokusebene 18 kann eine Trennung zwischen einem Strahlungsquellenmodul, aufweisend die Strahlungsquelle 3 und den Kollektor 17, und der Beleuchtungsoptik 4 darstellen.

Die Beleuchtungsoptik 4 umfasst einen Umlenkspiegel 19 und diesem im Strahlengang nachgeordnet einen ersten Facettenspiegel 20. Bei dem Umlenkspiegel 19 kann es sich um einen planen Umlenkspiegel oder alternativ um einen Spiegel mit einer über die reine Umlenkungswirkung hinaus bündelbeeinflussenden Wirkung handeln. Alternativ oder zusätzlich kann der Umlenkspiegel 19 als Spektralfilter ausgeführt sein, der eine Nutzlichtwellenlänge der Beleuchtungsstrahlung 16 von Falschlicht einer hiervon abweichenden Wellenlänge trennt. Sofern der erste Facettenspiegel 20 in einer Ebene der Beleuchtungsoptik 4 angeordnet ist, die zur Objektebene 6 als Feldebene optisch konjugiert ist, wird dieser auch als Feldfacettenspiegel bezeichnet. Der erste Facettenspiegel 20 umfasst eine Vielzahl von einzelnen ersten Facetten 21, welche im Folgenden auch als Feldfacetten bezeichnet werden. Von diesen Facetten 21 sind in der Fig. 1 nur beispielhaft einige dargestellt.

Die ersten Facetten 21 können als makroskopische Facetten ausgeführt sein, insbesondere als rechteckige Facetten oder als Facetten mit bogenförmiger oder teilkreisförmiger Randkontur. Die ersten Facetten 21 können als plane Facetten oder alternativ als konvex oder konkav gekrümmte Facetten ausgeführt sein.

Wie beispielsweise aus der DE 10 2008 009 600 A1 bekannt ist, können die ersten Facetten 21 selbst jeweils auch aus einer Vielzahl von Einzelspiegeln, insbesondere einer Vielzahl von Mikrospiegeln, zusammengesetzt sein. Der erste Facettenspiegel 20 kann insbesondere als mikroelektromechanisches System (MEMS-System) ausgebildet sein. Für Details wird auf die DE 10 2008 009 600 A1 verwiesen.

Zwischen dem Kollektor 17 und dem Umlenkspiegel 19 verläuft die Beleuchtungsstrahlung 16 horizontal, also längs der y-Richtung.

Im Strahlengang der Beleuchtungsoptik 4 ist dem ersten Facettenspiegel 20 nachgeordnet ein zweiter Facettenspiegel 22. Sofern der zweite Facettenspiegel 22 in einer Pupillenebene der Beleuchtungsoptik 4 angeordnet ist, wird dieser auch als Pupillenfacettenspiegel bezeichnet. Der zweite Facettenspiegel 22 kann auch beabstandet zu einer Pupillenebene der Beleuchtungsoptik 4 angeordnet sein. In diesem Fall wird die Kombination aus dem ersten Facettenspiegel 20 und dem zweiten Facettenspiegel 22 auch als spekularer Reflektor bezeichnet. Spekulare Reflektoren sind bekannt aus der US 2006/0132747 A1, der EP 1 614 008 B1 und der US 6,573,978.

Der zweite Facettenspiegel 22 umfasst eine Mehrzahl von zweiten Facetten 23. Die zweiten Facetten 23 werden im Falle eines Pupillenfacettenspiegels auch als Pupillenfacetten bezeichnet.

Bei den zweiten Facetten 23 kann es sich ebenfalls um makroskopische Facetten, die beispielsweise rund, rechteckig oder auch hexagonal berandet sein können, oder alternativ um aus Mikrospiegeln zusammengesetzte Facetten handeln. Diesbezüglich wird ebenfalls auf die DE 10 2008 009 600 A1 verwiesen.

Die zweiten Facetten 23 können plane oder alternativ konvex oder konkav gekrümmte Reflexionsflächen aufweisen.

Die Beleuchtungsoptik 4 bildet somit ein doppelt facettiertes System. Dieses grundlegende Prinzip wird auch als Wabenkondensor (Fly's Eye Integrator) bezeichnet.

Es kann vorteilhaft sein, den zweiten Facettenspiegel 22 nicht exakt in einer Ebene, welche zu einer Pupillenebene der Projektionsoptik 10 optisch konjugiert ist, anzuordnen. Insbesondere kann der Pupillenfacettenspiegel 22 gegenüber einer Pupillenebene der Projektionsoptik 10 verkippt angeordnet sein, wie es zum Beispiel in der DE 10 2017 220 586 A1 beschrieben ist.

Mit Hilfe des zweiten Facettenspiegels 22 werden die einzelnen ersten Facetten 21 in das Objektfeld 5 abgebildet. Der zweite Facettenspiegel 22 ist der letzte bündelformende oder auch tatsächlich der letzte Spiegel für die Beleuchtungsstrahlung 16 im Strahlengang vor dem Objektfeld 5.

Bei einer weiteren, nicht dargestellten Ausführung der Beleuchtungsoptik 4 kann im Strahlengang zwischen dem zweiten Facettenspiegel 22 und dem Objektfeld 5 eine Übertragungsoptik angeordnet sein, die insbesondere zur Abbildung der ersten Facetten 21 in das Objektfeld 5 beiträgt. Die Übertragungsoptik kann genau einen Spiegel, alternativ aber auch zwei oder mehr Spiegel aufweisen, welche hintereinander im Strahlengang der Beleuchtungsoptik 4 angeordnet sind. Die Übertragungsoptik kann insbesondere einen oder zwei Spiegel für senkrechten Einfall (NI-Spiegel, Normal Incidence Spiegel) und/oder einen oder zwei Spiegel für streifenden Einfall (GI-Spiegel, Gracing Incidence Spiegel) umfassen.

Die Beleuchtungsoptik 4 hat bei der Ausführung, die in der Fig. 1 gezeigt ist, nach dem Kollektor 17 genau drei Spiegel, nämlich den Umlenkspiegel 19, den Feldfacettenspiegel 20 und den Pupillenfacettenspiegel 22.

Bei einer weiteren Ausführung der Beleuchtungsoptik 4 kann der Umlenkspiegel 19 auch entfallen, so dass die Beleuchtungsoptik 4 nach dem Kollektor 17 dann genau zwei Spiegel aufweisen kann, nämlich den ersten Facettenspiegel 20 und den zweiten Facettenspiegel 22.

Die Abbildung der ersten Facetten 21 mittels der zweiten Facetten 23 beziehungsweise mit den zweiten Facetten 23 und einer Übertragungsoptik in die Objektebene 6 ist regelmäßig nur eine näherungsweise Abbildung.

Die Projektionsoptik 10 umfasst eine Mehrzahl von Spiegeln Mi, welche gemäß ihrer Anordnung im Strahlengang der Projektionsbelichtungsanlage 1 durchnummeriert sind.

Bei dem in der Figur 1 dargestellten Beispiel umfasst die Projektionsoptik 10 sechs Spiegel M1 bis M6. Alternativen mit vier, acht, zehn, zwölf oder einer anderen Anzahl an Spiegeln Mi sind ebenso möglich. Der vorletzte Spiegel M5 und der letzte Spiegel M6 haben jeweils eine Durchtrittsöffnung für die Beleuchtungsstrahlung 16. Bei der Projektionsoptik 10 handelt es sich um eine doppelt obskurierte Optik. Die Projektionsoptik 10 hat eine bildseitige numerische Apertur, die größer ist als 0,5 und die auch größer sein kann als 0,6 und die beispielsweise 0,7 oder 0,75 betragen kann.

Reflexionsflächen der Spiegel Mi können als Freiformflächen ohne Rotationssymmetrieachse ausgeführt sein. Alternativ können die Reflexionsflächen der Spiegel Mi als asphärische Flächen mit genau einer Rotationssymmetrieachse der Reflexionsflächenform gestaltet sein. Die Spiegel Mi können, genauso wie die Spiegel der Beleuchtungsoptik 4, hoch reflektierende Beschichtungen für die Beleuchtungsstrahlung 16 aufweisen. Diese Beschichtungen können als Multilayer-Beschichtungen, insbesondere mit alternierenden Lagen aus Molybdän und Silizium, gestaltet sein.

Die Projektionsoptik 10 hat einen großen Objekt-Bildversatz in der y-Richtung zwischen einer y-Koordinate eines Zentrums des Objektfeldes 5 und einer y-Koordinate des Zentrums des Bildfeldes 11. Dieser Objekt-Bild-Versatz in der y-Richtung kann in etwa so groß sein wie ein z-Abstand zwischen der Objektebene 6 und der Bildebene 12.

Die Projektionsoptik 10 kann insbesondere anamorphotisch ausgebildet sein. Sie weist insbesondere unterschiedliche Abbildungsmaßstäbe βx, βy in x- und y-Richtung auf. Die beiden Abbildungsmaßstäbe βx, βy der Projektionsoptik 10 liegen bevorzugt bei (βx, βy) = (+/- 0,25, +/- 0,125). Ein positiver Abbildungsmaßstab β bedeutet eine Abbildung ohne Bildumkehr. Ein negatives Vorzeichen für den Abbildungsmaßstab β bedeutet eine Abbildung mit Bildumkehr.

Die Projektionsoptik 10 führt somit in x-Richtung, das heißt in Richtung senkrecht zur Scanrichtung, zu einer Verkleinerung im Verhältnis 4:1.

Die Projektionsoptik 10 führt in y-Richtung, das heißt in Scanrichtung, zu einer Verkleinerung von 8:1.

Andere Abbildungsmaßstäbe sind ebenso möglich. Auch vorzeichengleiche und absolut gleiche Abbildungsmaßstäbe in x- und y-Richtung, zum Beispiel mit Absolutwerten von 0,125 oder von 0,25, sind möglich.

Die Anzahl von Zwischenbildebenen in der x- und in der y-Richtung im Strahlengang zwischen dem Objektfeld 5 und dem Bildfeld 11 kann gleich sein oder kann, je nach Ausführung der Projektionsoptik 10, unterschiedlich sein. Beispiele für Projektionsoptiken mit unterschiedlichen Anzahlen derartiger Zwischenbilder in x- und y-Richtung sind bekannt aus der US 2018/0074303 A1.

Jeweils eine der Pupillenfacetten 23 ist genau einer der Feldfacetten 21 zur Ausbildung jeweils eines Beleuchtungskanals zur Ausleuchtung des Objektfeldes 5 zugeordnet. Es kann sich hierdurch insbesondere eine Beleuchtung nach dem Köhlerschen Prinzip ergeben. Das Fernfeld wird mit Hilfe der Feldfacetten 21 in eine Vielzahl an Objektfeldern 5 zerlegt. Die Feldfacetten 21 erzeugen eine Mehrzahl von Bildern des Zwischenfokus auf den diesen jeweils zugeordneten Pupillenfacetten 23.

Die Feldfacetten 21 werden jeweils von einer zugeordneten Pupillenfacette 23 einander überlagernd zur Ausleuchtung des Objektfeldes 5 auf das Retikel 7 abgebildet. Die Ausleuchtung des Objektfeldes 5 ist insbesondere möglichst homogen. Sie weist vorzugsweise einen Uniformitätsfehler von weniger als 2 % auf. Die Felduniformität kann über die Überlagerung unterschiedlicher Beleuchtungskanäle erreicht werden.

Durch eine Anordnung der Pupillenfacetten kann geometrisch die Ausleuchtung der Eintrittspupille der Projektionsoptik 10 definiert werden. Durch Auswahl der Beleuchtungskanäle, insbesondere der Teilmenge der Pupillenfacetten, die Licht führen, kann die Intensitätsverteilung in der Eintrittspupille der Projektionsoptik 10 eingestellt werden. Diese Intensitätsverteilung wird auch als Beleuchtungssetting bezeichnet.

Eine ebenfalls bevorzugte Pupillenuniformität im Bereich definiert ausgeleuchteter Abschnitte einer Beleuchtungspupille der Beleuchtungsoptik 4 kann durch eine Umverteilung der Beleuchtungskanäle erreicht werden.

Im Folgenden werden weitere Aspekte und Details der Ausleuchtung des Objektfeldes 5 sowie insbesondere der Eintrittspupille der Projektionsoptik 10 beschrieben.

Die Projektionsoptik 10 kann insbesondere eine homozentrische Eintrittspupille aufweisen. Diese kann zugänglich sein. Sie kann auch unzugänglich sein.

Die Eintrittspupille der Projektionsoptik 10 lässt sich regelmäßig mit dem Pupillenfacettenspiegel 22 nicht exakt ausleuchten. Bei einer Abbildung der Projektionsoptik 10, welche das Zentrum des Pupillenfacettenspiegels 22 telezentrisch auf den Wafer 13 abbildet, schneiden sich die Aperturstrahlen oftmals nicht in einem einzigen Punkt. Es lässt sich jedoch eine Fläche finden, in welcher der paarweise bestimmte Abstand der Aperturstrahlen minimal wird. Diese Fläche stellt die Eintrittspupille oder eine zu ihr konjugierte Fläche im Ortsraum dar. Insbesondere zeigt diese Fläche eine endliche Krümmung.

Es kann sein, dass die Projektionsoptik 10 unterschiedliche Lagen der Eintrittspupille für den tangentialen und für den sagittalen Strahlengang aufweist. In diesem Fall sollte ein abbildendes Element, insbesondere ein optisches Bauelement der Übertragungsoptik, zwischen dem zweiten Facettenspiegel 22 und dem Retikel 7 bereitgestellt werden. Mit Hilfe dieses optischen Elements kann die unterschiedliche Lage der tangentialen Eintrittspupille und der sagittalen Eintrittspupille berücksichtigt werden.

Bei der in der Figur 1 dargestellten Anordnung der Komponenten der Beleuchtungsoptik 4 ist der Pupillenfacettenspiegel 22 in einer zur Eintrittspupille der Projektionsoptik 10 konjugierten Fläche angeordnet. Der Feldfacettenspiegel 20 ist verkippt zur Objektebene 6 angeordnet. Der erste Facettenspiegel 20 ist verkippt zu einer Anordnungsebene angeordnet, die vom Umlenkspiegel 19 definiert ist.

Der erste Facettenspiegel 20 ist verkippt zu einer Anordnungsebene angeordnet, die vom zweiten Facettenspiegel 22 definiert ist.

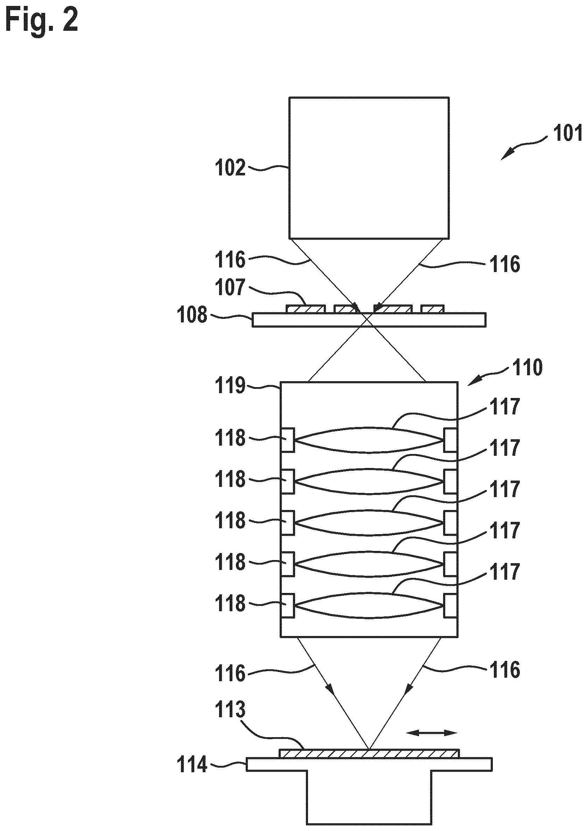

Figur 2 zeigt schematisch im Meridionalschnitt eine weitere Projektionsbelichtungsanlage 101 für die DUV-Projektionslithografie, in welcher die Erfindung ebenfalls zur Anwendung kommen kann.

Der Aufbau der Projektionsbelichtungsanlage 101 und das Prinzip der Abbildung ist vergleichbar mit dem in Figur 1 beschriebenen Aufbau und Vorgehen. Gleiche Bauteile sind mit einem um 100 gegenüber Figur 1 erhöhten Bezugszeichen bezeichnet, die Bezugszeichen in Figur 2 beginnen also mit 101.

Im Unterschied zu einer wie in Figur 1 beschriebenen EUV-Projektionsbelichtungsanlage 1 können auf Grund der größeren Wellenlänge der als Nutzlicht verwendeten DUV-Strahlung 116 im Bereich von 100 nm bis 300 nm, insbesondere von 193 nm, in der DUV-Projektionsbelichtungsanlage 101 zur Abbildung beziehungsweise zur Beleuchtung refraktive, diffraktive und/oder reflexive optische Elementen 117, wie beispielsweise Linsen, Spiegeln, Prismen, Abschlussplatten und dergleichen verwendet werden. Die Projektionsbelichtungsanlage 101 umfasst dabei im Wesentlichen ein Beleuchtungssystem 102, einen Retikelhalter 108 zur Aufnahme und exakten Positionierung eines mit einer Struktur versehenen Retikels 107, durch welches die späteren Strukturen auf einem Wafer 113 bestimmt werden, einen Waferhalter 114 zur Halterung, Bewegung und exakten Positionierung eben dieses Wafers 113 und einem Projektionsobjektiv 110, mit mehreren optischen Elementen 117, die über Fassungen 118 in einem Objektivgehäuse 119 des Projektionsobjektives 110 gehalten sind.

Das Beleuchtungssystem 102 stellt eine für die Abbildung des Retikels 107 auf dem Wafer 113 benötigte DUV-Strahlung 116 bereit. Als Quelle für diese Strahlung 116 kann ein Laser, eine Plasmaquelle oder dergleichen Verwendung finden. Die Strahlung 116 wird in dem Beleuchtungssystem 102 über optische Elemente derart geformt, dass die DUV-Strahlung 116 beim Auftreffen auf das Retikel 107 die gewünschten Eigenschaften hinsichtlich Durchmesser, Polarisation, Form der Wellenfront und dergleichen aufweist.

Der Aufbau der nachfolgenden Projektionsoptik 101 mit dem Objektivgehäuse 119 unterscheidet sich außer durch den zusätzlichen Einsatz von refraktiven optischen Elementen 117 wie Linsen, Prismen, Abschlussplatten prinzipiell nicht von dem in Figur 1 beschriebenen Aufbau und wird daher nicht weiter beschrieben.

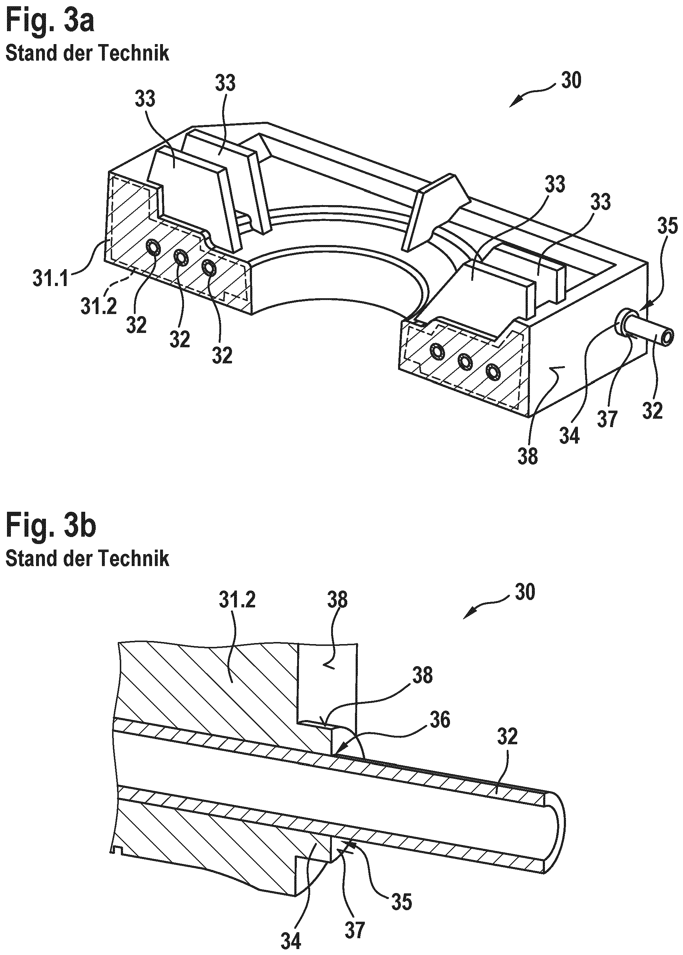

Figur 3a zeigt ein aus dem Stand der Technik bekanntes als Kühlmantel ausgebildetes Modul 30, wie es in einer in der Figur 1 erläuterten Projektionsbelichtungsanlage Anwendung finden kann. Das Modul 30 wird durch ein Gießverfahren hergestellt, wobei das in der Figur 3a dargestellte Modul 30 den Zustand nach dem Gießen zeigt. Das Modul 30 weist einen Grundkörper 31.1, 31.2 auf, wobei der Grundkörper 31.1 die Geometrie nach dem Gießen und der Grundkörper 31.2 die Geometrie nach der dem Gießen nachfolgenden Nachbearbeitung, insbesondere Fräsen, darstellt. Die Geometrie des nachbearbeiteten Grundkörpers 31.2 ist in der Figur 3a mit gestrichelten Linien dargestellt.

Im gegossenen Grundkörper 31.1, 31.2 ist eine als Kühlleitung 32 ausgebildete Röhre angeordnet. Die Kühlleitung 32 wird durch Stützstrukturen 33 in der nicht dargestellten Gussform positioniert und beim Gießen vom Material des Grundkörpers 31.1 vollständig umschlossen, wobei an mindestens einer Stelle die Kühlleitung 32 eine Seite des Grundkörper 31.1, 31.2 durchdringt. Durch die höhere Wärmedehnung des für den Grundkörper 31.1, 31.2 verwendeten Aluminiums gegenüber dem für die Kühlleitung 32 verwendeten Edelstahl ist die formschlüssige Verbindung spaltfrei. Die spaltfreie Verbindung gewährleistet einen guten Wärmeübergang zwischen dem Grundkörper 31.1, 31.2 und der Fluid führenden Kühlleitung 32, was sich positiv auf die Kühlleistung auswirkt.

Die Kühlleitung 32 durchdringt den Grundkörper 31.1, 31.2 an einer am Grundkörper 31.1, 31.2 ausgebildeten Nase 34, wodurch eine Schnittstelle 35 zwischen der Zuleitung 32 und dem Grundkörper 31.1, 31.2 ausgebildet wird. Die Nase 34 verhindert bei der Nachbearbeitung der Oberfläche 38 des Grundkörpers 31.1 vorteilhaft eine Beschädigung, beispielsweise durch einen Fräskopf, der Kühlleitung 32. Gleichzeitig ist eine Nachbearbeitung der Stirnfläche 37 der Nase 34 nicht ohne die Gefahr einer Beschädigung der Kühlleitung 32 möglich, wodurch eine nur mit einem vergleichsweise hohem Aufwand zu reinigende Oberfläche 37 am Grundkörpers bestehen bleibt.

Figur 3b zeigt ein Detail des Moduls 30, welches die Schnittstelle 35 zwischen dem bereits an der Oberfläche 38 und an der Mantelfläche 38 der Nase 34 nachgearbeiteten Grundkörper 31.2 und der Kühlleitung 32 im Bereich der Nase 34 darstellt.

Durch die Kapillarwirkung bzw. die Oberflächenspannung des flüssigen Aluminiums beim Gießen kann es an der Schnittstelle 35 zwischen Kühlleitung 32 und Grundkörper 31.2 im Bereich der Nase 34 zu einem Spalt 36 kommen. Dieser und die nicht nachbearbeitbare Stirnfläche 37 der Nase 34 sind nur schwer zu reinigen und können zu einer Kontamination der Projektionsbelichtungsanlage 1 (Figur 1), insbesondere der Spiegel Mx, führen.

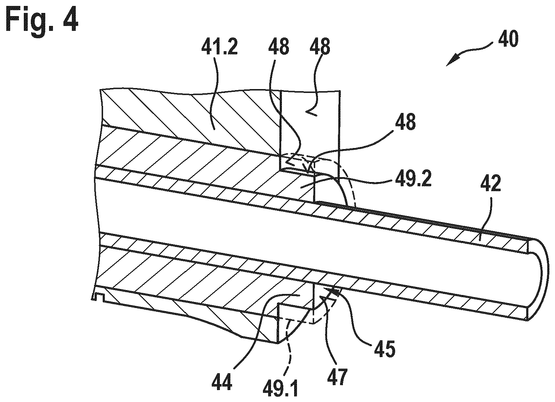

Figur 4 zeigt ein Detail eines erfindungsgemäßen Moduls 40, welches einen grundsätzlich vergleichbaren Aufbau wie das aus dem Stand der Technik bekannte Modul 30 (Figur 3a) aufweist, wobei wo sinnvoll einander entsprechende Elemente mit gegenüber der Figur 3a und der Figur 3b um 10 erhöhten Bezugszeichen bezeichnet sind. Das Detail zeigt, wie bereits in der Figur 3b, die Schnittstelle 45, an welcher die Kühlleitung 42 den Grundkörper 41.2 durchdringt. Der Grundkörper 41.2 ist in der Figur 4 bereits in dem durch Nachbearbeitung der Oberflächen 48 aus dem gegossenen Zustand des Grundkörpers (nicht dargestellt) hergestellten Zustand dargestellt.

Die Kühlleitung 42 ist im gezeigten Beispiel aus Edelstahl hergestellt, wobei der Grundkörper 41.2 Aluminium aufweist. Alternativ können auch andere Werkstoffe für die Kühlleitung 42 und den Grundkörper 41.2 Anwendung finden, wie beispielsweise Kupfer für den Grundkörper 41.2 und Edelstahl für die Kühlleitung 42.

Die Kühlleitung 42 ist im Bereich des Austritts aus dem Grundkörper 41.2 von einer Hülse 49.1, 49.2 umgeben, welche vor dem in der Figur 3a erläuterten Positionieren der Kühlleitung 42 in der Gussform auf die Kühlleitung 42 aufgeschrumpft wird.

Alternativ zum Aufschrumpfen können auch andere Verfahren, wie beispielweise Klemmen, Kleben, Schweißen, Löten oder andere Verfahren Anwendung finden. Das alternative Verfahren zur Verbindung der Hülse 49.1, 49.2 muss eine spaltfreie Verbindung zwischen der Kühlleitung 42 und der Hülse 49.1, 49.2, insbesondere am Austritt der Kühlleitung 42 aus der Hülse 49.1, 49.2, gewährleisten und beständig gegen die beim Gießvorgang auftretenden Temperaturen sein. Weiterhin muss die Verbindung ohne Nachbearbeitung die Anforderungen an die Oberflächenrauheiten, wie oben erläutert, erfüllen.

Im Gegensatz zu dem in der Figur 3a erläuterten Beispiel wird die Nase 44 durch die über den Rand des Grundkörpers 41.2 herausstehende Hülse 49.1, 49.2 gebildet.

Weiterhin ist die Hülse 49.1, 49.2 im gezeigten Ausführungsbeispiel aus demselben Material wie der Grundkörper 41.2, also Aluminimum. Beim Gießen des Grundkörpers 41.2 wird die Hülse 49.1 leicht angeschmolzen, ohne dabei die Form zu verlieren, so dass die Positionierung der Kühlleitung 42 im Grundkörper 41.2 im Rahmen der festgelegten Anforderungen erfüllt wird.

Die Stirnfläche 47 der Hülse 49.1, 49.2 ist, wie weiter oben erläutert, bereits vor dem Aufschrumpfen in einer für die Reinigung ausreichenden Qualität bearbeitet. Die Mantelfläche 48 der Hülse 49.1, 49.2 und die Oberflächen 48 des Grundkörpers 41.2 werden nach dem Gießvorgang, wie aus dem Stand der Technik bekannt, nachbearbeitet. Ein möglicherweise an der Schnittstelle zwischen der Hülse 49.1, 49.2 und dem Grundkörper 41.2 entstehender Spalt, welcher üblicherweise nur wenige Zehntel Millimeter tief ist, kann durch einen korrespondierenden Materialabtrag leicht entfernt werden. Im Ergebnis ergibt sich ein spaltfreier und gut zu reinigender Austritt der Kühlleitung 42 aus dem Grundkörper 41.2.

### Bezugszeichenliste

- 30: Kühlmantel
- 31.1,31.2: Grundkörper
- 32: Kühlleitung
- 33: Stützstruktur
- 34: Nase
- 35: Schnittstelle Kühlleitung/Grundkörper
- 36: Spalt
- 37: nicht bearbeitbare Stirnfläche
- 38: nachbearbeitete Flächen
- 40: Kühlmantel
- 41.2: Grundkörper
- 42: Kühlleitung
- 44: Nase
- 45: Schnittstelle Kühlleitung/Grundkörper
- 47: vorbearbeitete Stirnfläche
- 48: nachbearbeitete Flächen
- 49.1,49.2: Hülse

## Patentansprüche

1. Verfahren zur Herstellung eines Moduls (40) für die Halbleiterlithografie mit einem Grundkörper (41.2), wobei in dem Grundkörper (41.2) mindestens ein Rohr (42) angeordnet ist, welches den Grundkörper (41.2) an mindestens einer Stelle (45) durchdringt, mit folgenden Verfahrensschritten:
- Fügen einer Hülse (49.1,49.2) mit dem Rohr 42 im Bereich des Austritts (45) des Rohrs (42) aus dem Grundkörper (41.2),
- Positionierung des Rohrs (42) in einer Gussform zur Herstellung des Grundkörpers (41.2),
- Gießen des Grundkörpers (41.2),
- Nachbearbeitung des Grundkörpers (41.2).

2. Verfahren nach Anspruch 1,
**dadurch gekennzeichnet, dass**
das Rohr (42) durch mindestens eine Stützstruktur (33) in der Gussform positioniert wird.

3. Verfahren nach einem der Ansprüche 1 oder 2,
**dadurch gekennzeichnet, dass**
das Rohr (42), die Hülse (49.1,49.2) und die Stützstrukturen (33) beim Gießen zumindest teilweise von der Schmelze umschlossen werden.

4. Verfahren nach einem der Ansprüche 2 oder 3,
**dadurch gekennzeichnet, dass**
die Hülse (49.1,49.2) und/oder die Stützstrukturen (33) beim Gießen zumindest teilweise von der Schmelze angeschmolzen werden.

5. Verfahren nach einem der vorangehenden Ansprüche,
**dadurch gekennzeichnet, dass**
mindesten eine Stirnfläche (47) der Hülse (49.1, 49.2) vor dem Fügen mit dem Rohr (42) mindestens eine Oberflächenrauheit von kleiner als Rz 6,3, bevorzugt von kleiner als Rz 2,5 und besonders bevorzugt von kleiner Rz 1,0
aufweist.

6. Verfahren nach einem der Ansprüche 2 bis 5,
**dadurch gekennzeichnet, dass**
die Stützstrukturen und die Hülse (49.1, 49.2) aus demselben Material wie der Grundkörper (41.2) hergestellt werden.

7. Verfahren nach einem der vorangehenden Ansprüche,
**dadurch gekennzeichnet, dass**
die Hülse (49.1, 49.2) und/oder die Mantelfläche (48) des Gehäuses (41.2) nach dem Gießen des Grundkörpers (41.2) zumindest teilweise zur Herstellung einer spaltfreien Verbindung zwischen Hülse (49.1, 49.2) und dem Grundkörper (41.2) nachgearbeitet werden und/oder die Hülse (49.1, 49.2) zur Herstellung einer Oberflächenrauheit von kleiner als Rz 6,3, bevorzugt von kleiner als Rz 2,5 und besonders bevorzugt von kleiner Rz 1,0 nachgearbeitet, insbesondere spanend nachgearbeitet wird.

8. Modul (40) für die Halbleiterlithografie mit einem Grundkörper (41.2), wobei in dem Grundkörper (41.2) mindestens ein Rohr (42) angeordnet ist, welches den Grundkörper (41.2) an mindestens einer Stelle durchdringt,
**dadurch gekennzeichnet, dass**
das Rohr (42) spaltfrei von einer Hülse (49.1,49.2) umschlossen ist.

9. Modul (40) nach Anspruch 8,
**dadurch gekennzeichnet, dass**
eine Hülse (49.1,49.2) des Moduls (40) spaltfrei vom Grundkörper (41.2) umschlossen ist.

10. Modul (40) nach einem der Ansprüche 8 oder 9,
**dadurch gekennzeichnet, dass**
die Oberfläche (48) des Moduls (40) eine Oberflächenrauheit von kleiner als Rz 6,3, bevorzugt von kleiner als Rz 2,5 und besonders bevorzugt von kleiner Rz 1,0 aufweist.

11. Modul (40) nach einem der Ansprüche 8 bis 10,
**dadurch gekennzeichnet, dass**
die Hülse (49.1,49.2) und/oder eine Stützstruktur (33) zur Positionierung des Rohrs (42) im Grundkörper (41.2) dasselbe Material wie der Grundkörper (41.2) aufweisen.
